# FASCICULE DE BREVET EUROPEEN

(11) **EP 0 755 119 B1**
(45) Date de publication et mention de la délivrance du brevet: **17.05.2000**
(21) Numéro de dépôt: 96401587.9
(22) Date de dépôt: 17.07.1996
(51) Int. Cl.: H03K 19/00, H03K 5/02, H03K 5/08

(54) **Dispositif de mise en forme d'un signal analogique en un signal rectangulaire**
Vorrichtung zur Umformung eines analogen Signals in ein rechteckförmiges Signal
Device for converting an analog signal into a square wave signal

(30) Priorité: 20.07.1995 FR 9508804
(43) Date de publication de la demande: 22.01.1997
(73) Titulaire: MHS, 44087 Nantes Cédex 03 (FR)
(72) Inventeur: Gerber, Rémi, 44300 Nantes Cedex (FR); Silloray, Janick, 44300 Nantes (FR)
(74) Mandataire: Fréchède, Michel

(56) Documents cités:
- EP-A- 0 350 462
- EP-A- 0 377 897
- EP-A- 0 476 871
- US-A- 4 392 105
- US-A- 4 714 901
- US-A- 4 953 187
- US-A- 5 250 914

## Description

La présente invention concerne un dispositif de mise en forme d'un signal analogique en un signal rectangulaire, et plus particulièrement un circuit réalisant la conversion d'un signal analogique d'entrée de type sinusoïdal, triangulaire ou carré en un signal rectangulaire de sortie.

Les dispositifs de mise en forme existants présentent divers inconvénients.

D'une part, la commutation vers les niveaux logiques haut et bas s'effectue par comparaison à une tension de référence généralement fournie par une alimentation extérieure au dispositif de mise en forme proprement dit. Cette introduction d'un élément extérieur augmente la complexité du circuit, et donc, le temps de conception et le coût de fabrication. De plus, elle comporte un risque d'engendrer dans le dispositif de mise en forme un bruit thermique susceptible de dégrader les performances de celui-ci. Enfin, elle induit une consommation statique de courant.

D'autre part, les dispositifs de mise en forme de l'art antérieur fonctionnent en continu, même durant certaines phases où, momentanément, aucune conversion n'est requise par le reste du circuit (appelé dans toute la suite *"coeur de la matrice").* Leur consommation de courant peut ainsi être considérable, en particulier lorsque le coeur de la matrice contient un grand nombre de portes logiques, par exemple, de l'ordre de grandeur de 600 000 ou même davantage.

La présente invention a pour objectif de remédier à ces inconvénients, en proposant un dispositif de mise en forme dépourvu de toute structure extérieure fournissant une tension de référence, et commandé de façon à adopter un mode "veille" en cas de non-utilisation.

Le premier aspect apporte une réduction de la complexité du circuit dessiné par le concepteur, et donc, un gain de surface, un gain de temps lors de la conception et une réduction du coût de fabrication, supprime le risque d'engendrer un bruit thermique additionnel, et évite une consommation statique de courant.

Le second aspect permet une diminution sensible de la consommation globale de courant.

De plus, la structure simplifiée du convertisseur proposé est d'emploi facile et modulable.

En outre, le circuit selon l'invention ne présente qu'une faible dépendance vis-à-vis de la charge placée en sortie, c'est-à-dire que la valeur de cette dernière, même importante, ne provoque qu'une déformation négligeable de la forme d'onde du signal rectangulaire de sortie.

Un dispositif de mise en forme d'un signal analogique en un signal rectangulaire, qui adopte un mode "veille" en cas de non-utilisation, est décrit dans le document EP-A-0 377 897.

Afin d'atteindre l'objectif défini ci-dessus, la présente invention propose un dispositif de mise en forme d'un signal analogique d'entrée en un signal rectangulaire de sortie, comprenant les éléments suivants.

Un module de commutation présentant deux seuils de déclenchement rapprochés et centrés, et comprenant une entrée et une sortie, délivre un signal commuté, le signal analogique d'entrée étant fourni à cette entrée à partir d'une première entrée externe par l'intermédiaire d'un condensateur de liaison.

Une porte logique NON-OU à deux entrées est prévue. Une première entrée de la porte, connectée en sortie du module de commutation, reçoit le signal commuté, et une deuxième entrée de la porte, connectée à une deuxième entrée externe du dispositif de mise en forme, reçoit un signal de commande de mise à l'état de veille, en non-utilisation du dispositif de mise en forme. La porte logique NON-OU permet, d'une part, en l'absence d'état de veille, la transmission à partir du signal commuté d'un signal commuté transmis, et, d'autre part, en présence de l'état de veille du dispositif de mise en forme, de délivrer un signal de sortie de valeur nulle, qui à son tour est appliqué à l'entrée du module de commutation pour imposer un signal analogique d'entrée de valeur nulle à l'entrée du module de commutation.

Un module de préamplification reçoit le signal commuté transmis et présente une première et une deuxième sortie délivrant un signal commuté préamplifié à partir du signal commuté transmis.

Un module d'amplification reçoit le signal commuté préamplifié et le signal de commande de mise à l'état de veille et délivre, soit le signal rectangulaire de sortie en l'absence de commande à l'état de veille, soit un signal de valeur nulle sur commande de mise à l'état de veille.

Dans un mode de réalisation particulier, le module de commutation peut comprendre deux transistors PMOS fournissant un premier seuil constitutif des seuils de déclenchement, deux transistors NMOS fournissant un second seuil constitutif des seuils de déclenchement, un transistor PMOS commutant en fonction de la différence de potentiel entre l'entrée du module de commutation et le premier seuil, un transistor NMOS commutant en fonction de la différence de potentiel entre l'entrée du module de commutation et le second seuil, et un inverseur constitué d'un transistor PMOS et d'un transistor NMOS et réalisant une amplification en courant.

Dans un mode de réalisation particulier, la porte logique NON-OU peut comprendre deux transistors NMOS en parallèle et deux transistors PMOS en série.

Dans un mode de réalisation particulier, le module de préamplification peut comprendre un inverseur constitué d'un transistor PMOS et d'un transistor NMOS, un premier étage d'amplification en courant formé de deux transistors PMOS et deux transistors NMOS, un deuxième étage d'amplification en courant formé de trois tampons successifs constitués chacun d'un transistor PMOS et d'un transistor NMOS, et dont une sortie constitue la première sortie du module de préamplification, et un module supplémentaire d'amplification en courant formé de deux inverseurs constitués chacun d'un transistor PMOS et d'un transistor NMOS, et dont l'entrée est connectée entre la sortie du premier étage d'amplification en courant et l'entrée du deuxième étage d'amplification en courant, et dont la sortie constitue la deuxième sortie du module de préamplification.

Dans un mode de réalisation particulier, le module d'amplification peut comprendre une impédance de contre-réaction constituée de deux transistors PMOS et d'un transistor NMOS, un transistor NMOS et un transistor PMOS pour piloter le condensateur extérieur connecté en sortie du module d'amplification, et un transistor PMOS contribuant, en présence de l'état de veille du dispositif de conversion, à délivrer un signal de sortie de valeur nulle.

D'autres caractéristiques et avantages de la présente invention ressortiront clairement à la lecture de la description détaillée suivante d'un mode particulier de réalisation, donné à titre d'exemple non limitatif. La description se réfère aux dessins annexés, dans lesquels :
- la figure 1 est une représentation schématique synoptique d'un dispositif de mise en forme d'un signal analogique en un signal rectangulaire conforme à la présente invention ;
- la figure 2 est un schéma électrique du circuit du dispositif de la présente invention, dans un mode de réalisation particulier à base de transistors MOS de type N et de type P ;
- les figures 3a et 3b représentent des chronogrammes des tensions aux entrées et aux sorties du dispositif de la présente invention dans le mode de réalisation de la figure 2, ainsi qu'une courbe donnant l'évolution temporelle de l'intensité du courant entre la sortie du module d'amplification et l'entrée du module de commutation, illustrant les résultats obtenus respectivement pour un signal analogique d'entrée sinusoïdal présentant une amplitude crête à crête de 1 volt et de 3 volts.

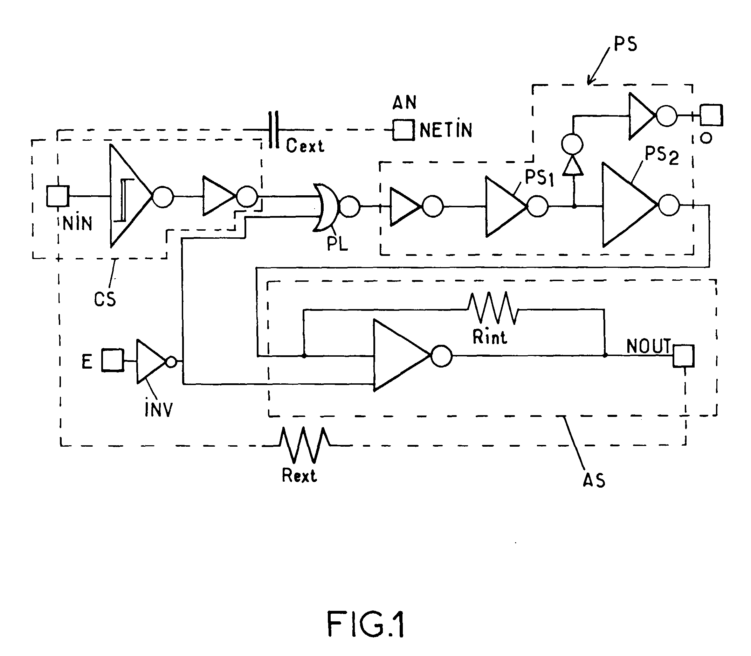

La structure du dispositif de mise en forme d'un signal analogique en un signal rectangulaire conforme à la présente invention, représentée sur la figure 1, va maintenant être décrite de façon détaillée. Sur cette figure, les connexions dessinées en tirets se rapportent à des éléments extérieurs au circuit convertisseur proprement dit.

Ce dernier convertit tout type de signaux d'entrée sinusoïdaux, triangulaires ou carrés ayant une amplitude crête à crête de 1 volt à 3 volts, sachant que la tension la plus faible est de 0 volt. Autrement dit, le dispositif de l'invention convertit des signaux d'entrée dont la valeur moyenne est comprise entre 0,5 volt et 1,5 volts, et l'amplitude entre 0,5 volt et 1,5 volts. Le résultat de cette conversion est un signal logique dont la forme d'onde est carrée, descendant jusqu'à une tension Vss (de 0 volt par exemple) au niveau bas et montant jusqu'à une tension Vdd (de 5 volts par exemple) au niveau haut.

De plus, le signal logique de sortie présente un rapport cyclique de 50% avec une tolérance de plus ou moins 10%. Ce rapport peut donc varier de 45% à 55%, en fonction de la valeur de la tension d'alimentation (4,5 à 5,5 volts), de la température (-55 à 145°C), de l'amplitude crête à crête en entrée (1 à 3 volts), et également en fonction de la vitesse du procédé de fabrication, qui dépend des tolérances de gravure (l'épaisseur de gravure est de 0,6 µm, avec une tolérance de 5 nm sur la longueur L des transistors et de 10 nm sur leur largeur W).

Enfin, le circuit de mise en forme de l'invention est capable de charger et de décharger un condensateur placé à sa sortie sans engendrer de déformation de la forme d'onde du signal logique de sortie pour une capacité de 1 à 60 picofarads.

Comme le montre la figure 1, le dispositif se compose de quatre éléments principaux : un module commutateur CS, une porte logique PL, un module préamplificateur PS et un module amplificateur AS.

Le module commutateur CS présente deux seuils de déclenchement Vc₁ et Vc₂ centrés sur la tension Vdd/2 et dont les valeurs sont voisines : la valeur absolue de la différence entre Vc₁ et Vc₂ vaut 4% de Vdd, soit 200 mV si Vdd = 5V. Il est à noter que l'écart entre les deux seuils est constant, même en cas de variation de la température par exemple (les deux seuils se déplacent ensemble). L'utilisation de seuils centrés est avantageuse du point de vue de la fabrication des transistors correspondants : ceux-ci sont symétriques, et donc, un éventuel défaut de fabrication sera lui aussi symétrique.

Soit AN le signal analogique d'entrée du dispositif de conversion et soit NOUT le signal rectangulaire de sortie. Le signal AN, constitué d'une composante statique et d'une composante dynamique, est fourni à une première entrée externe NETIN du dispositif. Un condensateur Cext est connecté entre l'entrée externe NETIN et l'entrée NIN du module commutateur CS. Le rôle du condensateur Cext est de supprimer la composante statique du signal analogique d'entrée AN, afin de fournir uniquement sa composante dynamique à l'entrée NIN du module commutateur CS. Ce module reçoit également à son entrée NIN le signal de sortie du module amplificateur AS, la sortie du module AS étant connectée à l'entrée NIN du module CS par l'intermédiaire d'une résistance Rext.

La sortie du module commutateur CS est connectée à une entrée d'une porte logique NON-OU PL, qui reçoit donc le signal commuté. La fonction de cette porte logique PL est d'assurer la mise à l'état de veille du dispositif de mise en forme selon l'invention. A cet effet, la seconde entrée de la porte NON-OU PL est connectée à une seconde entrée externe E du dispositif. Tant que celui-ci est effectivement utilisé, la porte PL transmet le signal commuté. Lorsque le dispositif de conversion n'est pas utilisé, l'entrée E est positionnée à 0 volt. Le signal de sortie NOUT du module amplificateur AS est donc nul, et est appliqué à l'entrée NIN du module commutateur CS. Le signal de sortie du module CS est également nul. Recevant en entrée le signal de l'entrée E complémenté par un inverseur INV, la porte PL envoie un signal nul dans le module préamplificateur PS, qui fournit un signal de sortie égal à Vdd. Le dispositif de mise en forme est donc bloqué et ne consomme pas de courant.

La fonction du module préamplificateur PS est de réaliser une amplification progressive du courant dynamique à transmettre au module amplificateur de sortie AS. Il permet également d'engendrer à une sortie 0 du dispositif un signal rectangulaire identique au signal rectangulaire de sortie NOUT. Cette sortie 0 permet de piloter des structures situées dans le coeur de la matrice sans que celles-ci soient affectées par le temps de propagation du dispositif de l'invention.

Le quatrième élément constitutif principal du dispositif de l'invention est le module amplificateur AS. Il comprend une impédance de contre-réaction Rint connectée entre la sortie du module AS et l'entrée du module AS qui est connectée à la sortie du module préamplificateur PS. Lorsque le dispositif de mise en forme est effectivement utilisé, c'est-à-dire en l'absence de commande de mise à l'état de veille, le module AS fournit un signal rectangulaire de sortie NOUT obtenu après conversion analogique-rectangulaire à partir du signal analogique d'entrée AN. Sur commande de mise à l'état de veille, comme décrit précédemment, le signal fourni à la deuxième entrée externe E du dispositif est nul (égal à Vss). L'inverseur INV fournit donc une tension Vdd à l'entrée du module AS à laquelle l'inverseur INV est connecté. Cela a pour effet de positionner la sortie du module AS, et donc l'entrée NIN du module CS, à 0 volt. L'état de veille est ainsi établi.

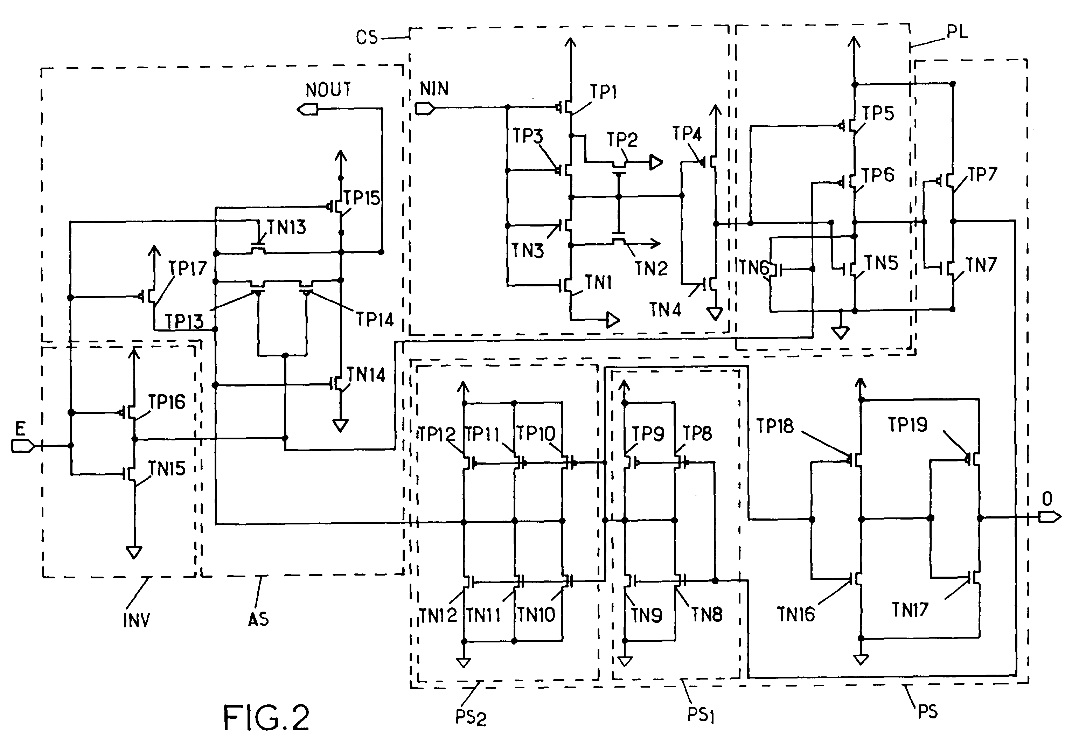

Dans un mode particulier de réalisation, les quatre éléments principaux du dispositif de l'invention sont réalisés à partir de transistors PMOS et NMOS. Le schéma électrique correspondant est représenté sur la figure 2. Les flèches représentent les connexions à la tension d'alimentation Vdd, et les triangles, les connexions à la tension de masse Vss. Sur cette figure, seul le dispositif de mise en forme analogique-rectangulaire proprement dit a été représenté. Ainsi, le condensateur Cext et la résistance Rext n'y figurent pas.

Les signes de référence se rapportant aux transistors PMOS commencent par "TP", et ceux désignant les transistors NMOS, par "TN". Ainsi, dans toute la suite, par souci de simplification, on désignera un transistor uniquement par le signe de référence correspondant, sans ajouter "PMOS" ou "NMOS".

Le module commutateur CS comprend les transistors TP1 à TP4 et TN1 à TN4. Les transistors TP1 et TP2 fournissent un premier seuil de déclenchement Vc₁, et les transistors TN1 et TN2 fournissent un second seuil de déclenchement Vc₂. Les transistors TP3 et TN3 subissent les variations du signal fourni à l'entrée NIN et commutent respectivement en fonction de la différence de potentiel entre l'entrée NIN et le seuil Vc₁, et en fonction de la différence de potentiel entre l'entrée NIN et le seuil Vc₂.

Du fait du dimensionnement des transistors d'entrée du module CS, à savoir, TP1 à TP3 et TN1 à TN3, la valeur moyenne du signal de sortie du module amplificateur AS, fournie à l'entrée NIN, est très proche des seuils de commutation Vc₁ et Vc₂ du module CS. Il convient donc de mettre en oeuvre les transistors d'entrée du module CS avec une précision relative élevée. C'est pourquoi on a choisi, pour les transistors TP1 à TP3 et TN1 à TN3, une longueur L plus élevée que pour les autres transistors du dispositif. En effet, l'imprécision relative sur la longueur, due au procédé de fabrication, sera dans ce cas plus faible que pour des transistors de faible longueur. A titre indicatif, les longueurs des transistors TP1 à TP3 et TN1 à TN3 sont de cinq à dix fois supérieures aux tailles minimales. De plus, les dimensions de ces transistors sont telles qu'elles permettent un comportement identique en tension et en température des seuils de déclenchement Vc₁, Vc₂ et de la valeur moyenne du signal de sortie du module amplificateur AS. Cela compense au mieux les dérives d'alimentation et les dérives thermiques, et donc, le rapport cyclique est ainsi préservé.

Les transistors TP4 et TN4, placés en sortie du module CS, forment un inverseur conservant le comportement en tension de ce module, tout en augmentant le courant de sortie afin de mieux commander le module suivant, c'est-à-dire la porte logique NON-OU PL.

Cette porte est de structure classique. Elle comprend deux transistors TN5, TN6 en parallèle et deux transistors TP5, TP6 en série. La porte PL reçoit à une entrée le signal de l'entrée E complémenté par l'inverseur INV mentionné précédemment, formé de deux transistors TP16 et TN15.

Le module préamplificateur PS comprend, connecté en sortie de la porte PL, un inverseur constitué de deux transistors TP7 et TN7, puis, connecté en sortie de celui-ci, un premier étage d'amplification en courant PS₁, constitué de quatre transistors TP8, TN8, TP9, TN9, puis un deuxième étage d'amplification en courant PS₂ connecté entre la sortie du premier étage d'amplification en courant PS₁ et une entrée du module amplificateur AS. Le deuxième étage PS₂ se compose de trois tampons inverseurs successifs présentant une capacité croissante à piloter en courant, c'est-à-dire que l'amplification du courant se fait de façon progressive. Ces trois tampons sont constitués chacun de deux transistors, respectivement TP10 et TN10, TP11 et TN11, TP12 et TN12.

Un module supplémentaire d'amplification en courant est connecté entre la sortie du premier étage PS₁ et l'entrée du deuxième étage PS₂. Il comprend deux inverseurs constitués chacun de deux transistors, respectivement TP18 et TN16, TP19 et TN17. La sortie de ce module supplémentaire d'amplification en courant constitue la sortie 0 mentionnée précédemment, prévue pour être connectée au coeur de la matrice.

L'impédance de contre-réaction Rint comprise dans le module amplificateur AS est constituée de trois transistors TN13, TP13 et TP14. Elle polarise en mode de conduction deux transistors TP15, TN14, placés en sortie du module AS, qui jouent le rôle d'un amplificateur de courant et servent à piloter un condensateur éventuellement connecté sur cette sortie. Les transistors TP15 et TN14 sont choisis de taille suffisamment élevée pour pouvoir piloter une capacité pouvant aller jusqu'à 60 picofarads.

Le module d'amplification de sortie AS comprend en outre un transistor TP17 qui, sur commande de mise à l'état de veille, contribue à l'établissement d'une tension Vdd en sortie du module préamplificateur PS. Avec le transistor TN14, le transistor TP17 permet également de positionner la sortie du module amplificateur AS à 0 volt.

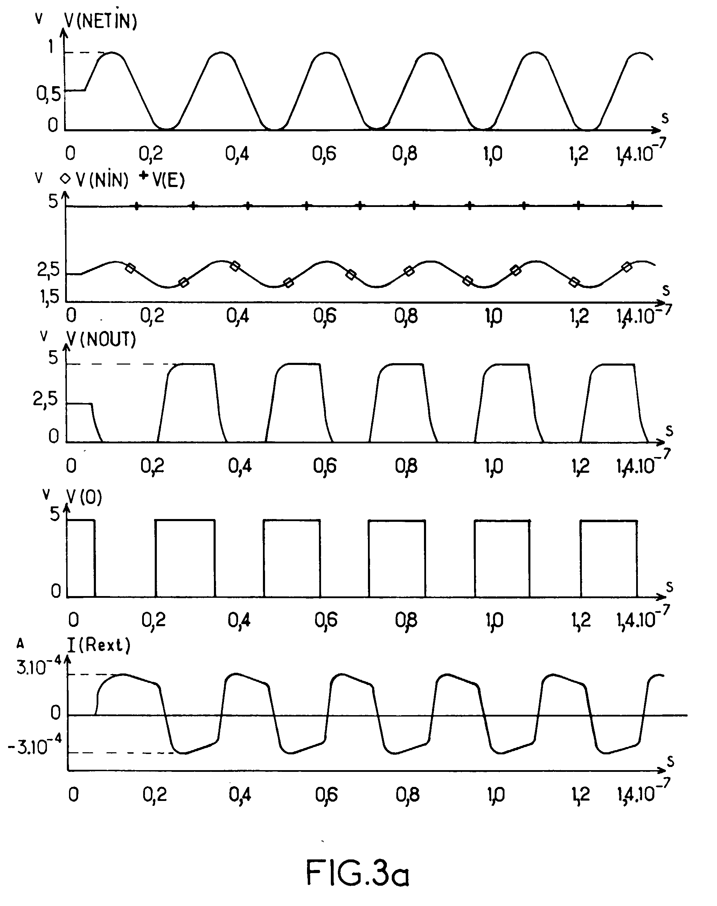

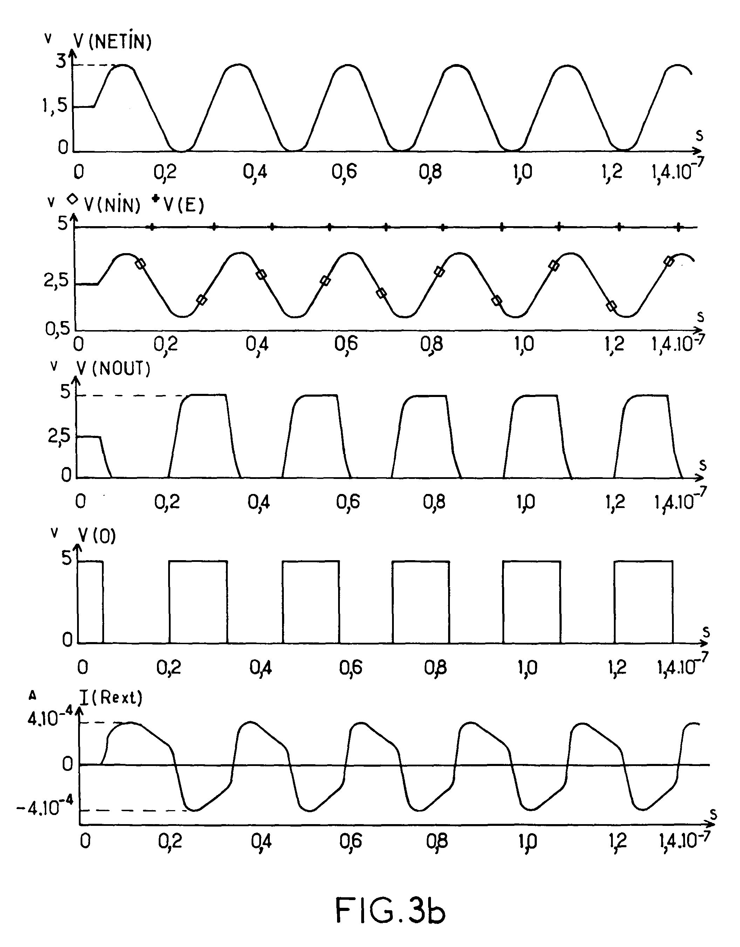

Les figures 3a et 3b donnent le résultat obtenu pour un signal analogique d'entrée sinusoïdal. Les courbes représentent, en fonction du temps, les tensions respectives, en volts, V(NETIN) à la première entrée externe NETIN du dispositif, V(E) à sa deuxième entrée externe E, V(NIN) à l'entrée NIN du module amplificateur AS (on y trouve le signal rectangulaire de sortie NOUT), et V(0) à la sortie 0 du module préamplificateur PS. Une courbe supplémentaire représente l'intensité, en ampères, I(Rext) du courant traversant la résistance Rext entre la sortie du module AS et l'entrée NIN du module CS.

La figure 3a illustre un cas dans lequel l'amplitude crête à crête du signal d'entrée AN sinusoïdal est de 1 V, et sa valeur moyenne, de 0,5 V. Dans le cas illustré, le dispositif est utilisé continûment, sans mise à l'état de veille. La tension à l'entrée E est donc constante et égale à Vdd = 5 V. Le signal de sortie NOUT est de forme pratiquement carrée. Le signal observé à la sortie 0, fourni au coeur de la matrice, est carré. Le signal de sortie NOUT présente quelques dégradations par rapport au signal de sortie en 0 car sa puissance est plus élevée. Toutefois, le rapport cyclique et la phase du signal de sortie NOUT sont identiques à ceux du signal observé en 0.

La figure 3b reprend les mêmes conditions de fonctionnement pour un signal d'entrée AN sinusoïdal d'amplitude crête à crête 3 V et de valeur moyenne 1,5 V.

## Revendications

1. Dispositif de mise en forme d'un signal analogique d'entrée (AN) en un signal rectangulaire de sortie (NOUT), comprenant :
- des moyens de commutation (CS) présentant deux seuils de déclenchement (Vc₁, Vc₂) rapprochés et centrés sur une tension (Vdd/2), et comprenant une entrée (NIN) et une sortie, délivrant un signal commuté, ledit signal analogique d'entrée (AN) étant fourni à ladite entrée (NIN) à partir d'une première entrée externe (NETIN) par l'intermédiaire d'un condensateur de liaison (Cext) ;
- une porte logique NON-OU (PL) à deux entrées, dont une première entrée, connectée en sortie desdits moyens de commutation (CS), reçoit ledit signal commuté, et dont une deuxième entrée, connectée à une deuxième entrée externe (E) du dispositif de mise en forme, reçoit un signal de commande de mise à l'état de veille, en non-utilisation du dispositif de mise en forme, ladite porte logique NON-OU (PL) permettant, d'une part, en l'absence d'état de veille, la transmission à partir dudit signal commuté d'un signal commuté transmis, et, d'autre part, en présence de l'état de veille du dispositif de mise en forme, de délivrer un signal rectangulaire de sortie (NOUT) de valeur nulle, qui à son tour est appliqué à ladite entrée (NIN) desdits moyens de commutation (CS) pour imposer un signal analogique d'entrée de valeur nulle à ladite entrée (NIN) desdits moyens de commutation (CS),
- des moyens de préamplification (PS) recevant ledit signal commuté transmis et présentant une première et une deuxième sortie, les moyens de préamplification (PS) permettant une amplification progressive du courant dynamique constitutif du signal commuté transmis et délivrant un signal commuté préamplifié à partir dudit signal commuté transmis ;
- des moyens d'amplification (AS) recevant ledit signal commuté préamplifié et ledit signal de commande de mise à l'état de veille et délivrant, soit ledit signal rectangulaire de sortie (NOUT) en l'absence de commande à l'état de veille, soit ledit signal de sortie de valeur nulle sur commande de mise à l'état de veille.

2. Dispositif selon la revendication 1, caractérisé en ce que ledit signal analogique d'entrée (AN) est de type sinusoïdal, triangulaire ou carré.

3. Dispositif selon la revendication 1, caractérisé en que lesdits moyens de commutation (CS) comprennent deux transistors PMOS (TP1, TP2) fournissant un premier seuil (Vc₁) constitutif desdits seuils de déclenchement (Vc₁, Vc₂), deux transistors NMOS (TN1, TN2) fournissant un second seuil (Vc₂) constitutif desdits seuils de déclenchement (Vc₁, Vc₂), un transistor PMOS (TP3) commutant en fonction de la différence de potentiel entre ladite entrée (NIN) et ledit premier seuil (Vc₁), un transistor NMOS (TN3) commutant en fonction de la différence de potentiel entre ladite entrée (NIN) et ledit second seuil (Vc₂), et un inverseur constitué d'un transistor PMOS (TP4) et d'un transistor NMOS (TN4) et réalisant une amplification en courant.

4. Dispositif selon la revendication 1, caractérisé en ce que ladite porte logique NON-OU (PL) comprend deux transistors NMOS (TN5, TN6) en parallèle et deux transistors PMOS (TP5, TP6) en série.

5. Dispositif selon la revendication 1, caractérisé en ce que lesdits moyens de préamplification (PS) comprennent un inverseur constitué d'un transistor PMOS (TP7) et d'un transistor NMOS (TN7), un premier étage d'amplification en courant (PS₁) formé de deux transistors PMOS (TP8, TP9) et deux transistors NMOS (TN8, TN9), un deuxième étage d'amplification en courant (PS₂) formé de trois tampons montés en parallèle, constitués chacun d'un transistor PMOS et d'un transistor NMOS (TP10, TN10 ; TP11, TN11 ; TP12, TN12), et dont une sortie constitue ladite première sortie des moyens de préamplification (PS), et un module supplémentaire d'amplification en courant formé de deux inverseurs constitués chacun d'un transistor PMOS et d'un transistor NMOS (TP18, TN16 ; TP19, TN17), et dont l'entrée est connectée entre la sortie dudit premier étage d'amplification en courant (PS₁) et l'entrée dudit deuxième étage d'amplification en courant (PS₂), et dont la sortie constitue ladite deuxième sortie des moyens de préamplification (PS) .

6. Dispositif selon la revendication 1, caractérisé en ce que lesdits moyens d'amplification (AS) comprennent une impédance (Rint) de contre-réaction constituée de deux transistors PMOS (TP13, TP14) et d'un transistor NMOS (TN13), un transistor NMOS (TN14) et un transistor PMOS (TP15) pour piloter ledit condensateur de liaison (Cext) connecté en sortie des moyens d'amplification (AS), et un transistor PMOS (TP17) contribuant, en présence de l'état de veille du dispositif de mise en forme, à délivrer ledit signal rectangulaire de sortie (NOUT) de valeur nulle.

## Patentansprüche

1. Vorrichtung zur Umformung eines analogen Eingangssignals (AN) in ein rechteckförmiges Ausgangssignal (NOUT), enthaltend:
- Umschaltmittel (CS) mit zwei bezüglich einer eine Spannung (Vdd/2) angenäherten und zentrierten Auslöseschwellen (Vc₁, Vc₂), wobei die Umschaltmittel einen Eingang (NIN) und einen Ausgang aufweisen, wobei der Ausgang ein Schaltsignal liefert und wobei das analoge Eingangssignal (AN) von einem ersten externen Eingangsanschluß (NETIN) über einen zwischengeschalteten Verbindungskondensator (Cext) dem Eingang (NIN) zugeführt wird;
- ein logisches NICHT-ODER-Gatter (PL) mit zwei Eingängen, dessen erster, mit dem Ausgang der Umschaltmittel (CS) verbundener Eingang das Schaltsignal empfängt und dessen zweiter, mit einem zweiten externen Ausgangsanschluß der Umformungsvorrichtung verbundene Eingang ein Steuersignal zum Setzen des Bereitschaftszustands empfängt und wobei bei Nichtverwendung der Umformungsvorrichtung das logische NICHT-ODER-Gatter (PL) einerseits bei Fehlen des Bereitschftszustands die Übertragung eines übertragenen Schaltsignals auf der Grundlage des Schaltsignals und andererseits bei Vorhandensein des Bereitschaftszustands die Abgabe eines rechteckförmigen Ausgangssignals (NOUT) vom Wert null erlaubt, wobei das Ausgangssignal auf seinem Weg dem Eingang (NIN) der Umschaltmittel (CS) zugeführt wird, um ein analoges Eingangssignal vom Wert null dem Eingang (NIN) der Umschaltmittel (CS) zu liefern,
- Vorverstärkermittel (PS), die das gesendete Schaltsignal empfangen und erste und zweite Ausgänge aufweisen, wobei die Vorverstärkermittel (PS) eine stufenlose Verstärkung des dynamischen Stroms auf der Grundlage des übertragenen Schaltsignals ermöglichen und ein vorverstärktes Schaltsignal auf der Grundlage des übertragenen Schaltsignals liefern;
- Verstärkermittel (AS), die das vorverstärkte Schaltsignal und das Steuersignal zum Setzen des Bereitschaftszustands empfangen und die entweder das rechteckige Ausgangssignal (NOUT) bei Fehlen des Befehls für den Bereitschaftszustand oder das Ausgangssignal vom Wert null bei Vorhandensein des Befehls für den Bereitschaftszustand liefern.

2. Vorrichtung nach Anspruch 1, dadurch gekennzeichnet, daß das analoge Eingangssignal (AN) sinusförmig, dreieckförmig oder rechteckförmig ist.

3. Vorrichtung nach Anspruch 1, dadurch gekennzeichnet, daß die Umschaltmittel (CS) folgende Bestandteile aufweisen: zwei Transistoren PMOS (TP1, TP2), die eine erste Schwelle (Vc₁) der Auslöseschwellen (Vc₁, Vc₂) liefern, zwei Transistoren NMOS (TN1, TN2), die eine zweite Schwelle (Vc₂) der Auslöseschwellen (Vc₁, Vc₂) liefern, einen Transistor PMOS (TP3), der in Abhängigkeit der Potentialdifferenz zwischen dem Eingang (NIN) und der ersten Schwelle (Vc₁) schaltet, einen Transistor NMOS (TN3), der in Abhängigkeit der Potentialdifferenz zwischen dem Eingang (NIN) und der zweiten Schwelle (Vc₂) schaltet, und einen durch einen Transistor PMOS (TP4) und einen Transistor NMOS (TN4) gebildeten Invertor und wobei die Umschaltmittel eine Stromverstärkung bewirken.

4. Vorrichtung nach Anspruch 1, dadurch gekennzeichnet, daß das logische NICHT-ODER-Gatter (PL) zwei parallel geschaltete Transistoren NMOS (TN5, TN6) und zwei in Serie geschaltete Transistoren PMOS (TP5, TP6) aufweist.

5. Vorrichtung nach Anspruch 1, dadurch gekennzeichnet, daß die Vorverstärkermittel (PS) folgende Bestandteile aufweisen: einen durch einen Transistor PMOS (TP7) und einen Transistor MNOS (TN7) gebildeten Invertor, eine durch zwei Transistoren PMOS (TP8, TP9) und zwei Transistoren NMOS (TN8, TN9) gebildete erste Stromverstärkerstufe (PS₁), eine zweite, durch drei parallel geschaltete Zwischenspeicher gebildete Stromverstärkerstufe (PS₂), wobei die Zwischenspeicher jeweils durch einen Transistor PMOS und einen Transistor NMOS (TP10, TN10; TP11, TN11; TP12, TN12) gebildet werden und wovon ein Ausgang den ersten Ausgang der Vorverstärkermittel (PS) bildet, und ein zusätzliches Modul zur Stromverstärkung, das durch zwei Invertoren gebildet wird, die jeweils einen Transistor PMOS und einen Transistor NMOS (TP18, TN16; TP19, TN17) aufweisen und wobei der Eingang mit dem Ausgang der ersten Stromverstärkerstufe (PS₁) und dem Eingang der zweiten Stromverstärkerstufe (PS₂) verbunden ist und wobei der Ausgang den zweiten Ausgang der Vorverstärkermittel (PS) bildet.

6. Vorrichtung nach Anspruch 1, dadurch gekennzeichnet, daß die Verstärkermittel (AS) folgende Bestandteile aufweisen: eine Gegenkopplungsimpedanz (Rint), die durch zwei Transistoren PMOS (TP13, TP14) und einen Transistor NMOS (TN13) gebildet wird, einen Transistor NMOS (TN14), einen Transistor PMOS (TP15), um den Verbindungskondensator (Cext) zu steuern, der mit dem Ausgang der Verstärkermittel (AS) verbunden ist, und einen Transistor PMOS (TP17), der im Bereitschaftszustand der Umformungsvorrichtung das rechteckförmige Ausgangssignal (NOUT) vom Wert null liefert.

## Claims

1. Device for shaping an analog input signal (AN) into a digital output signal (NOUT), comprising:
- switching means (CS) having two triggering thresholds (VC₁, VC₂) which are close and centered on a voltage (Vdd/2), and comprising an input (NIN) and an output delivering a switched signal, said analog input signal (AN) being delivered to said input (NIN) from a first external input (NETIN) via a connection capacitor (Cext);
- a NOR logic gate (PL) with two inputs, the first input of which, connected at the output of said switching means (CS), receives said switched signal and a second input of which, connected to a second external input (E) of the shaping device, receives a standby command signal when the shaping device is not being used, said NOR logic gate (PL) making it possible, on the one hand, in the absence of a standby mode, to transmit a transmitted switched signal based on said switched signal and, on the other hand, when the shaping device is in standby mode, to deliver a zero-value rectangular output signal (NOUT) which is in his turn applied to said input (NIN) of said switching means (CS) in order to impose a zero-value analog input signal on said input (NIN) of said switching means (CS);
- preamplification means (PS) receiving said transmitted switched signal and having a first and a second output, preamplification means (PS) making it possible to progressively amplify the dynamic current constituting the transmitted switched signal and delivering a preamplified switched signal based on said transmitted switched signal ;
- amplification means (AS) receiving said preamplified switched signal and said standby command signal and delivering either said rectangular output signal (NOUT), in the absence of a standby command, or said zero-value output signal in the event of a standby command.

2. Device according to Claim 1, characterized in that said analog input signal (NA) is of the sinusoidal, triangular or square type.

3. Device according to Claim 1, characterized in that said switching means (CS) comprise two PMOS transistors (TP1, TP2) providing a first threshold (VC₁) constituting triggering thresholds (VC₁, VC₂), two NMOS transistors (TN1, TN2) providing a second threshold (VC₂) constituting said triggering thresholds (VC₁, VC₂), a PMOS transistor (TP3) switching as a function of the potential difference between said input (NIN) and said first threshold (VC₁), an NMOS transistor (TN3) switching as a function of the potential difference between said input (NIN) and said second threshold (VC₂) and an inverter consisting of a PMOS transistor (TP4) and an NMOS transistor (TN4) and producing current amplification.

4. Device according to Claim 1, characterized in that said NOR logic gate (PL) comprises two NMOS transistors (TN5, TN6) in parallel and two PMOS transistors (TP5, TP6) in series.

5. Device according to Claim 1, characterized in that said preamplification means (PS) comprise an inverter consisting of a PMOS transistor (TP7) and an NMOS transistor (TN7), a first current amplification stage (PS₁) formed by two PMOS transistors (TP8, TP9) and two NMOS transistors (TN8, TN9), a second current amplification stage (PS₂) which is formed by three parallel-connected buffers, each consisting of one PMOS transistor and one NMOS transistor (TP10, TN10; TP11, TN11; TP12, TN12) and an output of which constitutes said first output of the preamplification means (PS), and an additional current amplification module which is formed by two inverters, each consisting of one PMOS transistor and one NMOS transistor (TP18, TN16; TP19, TN17) and the input of which is connected between the output of said first current amplification stage (PS₁) and the input of said second current amplification stage (PS₂) and the output of which constitutes said second output of the preamplification means (PS).

6. Device according to Claim 1, characterized in that said amplification means (AS) comprise a negative-feedback impedance (Rint) consisting of two PMOS transistors (TP13, TP14) and of one NMOS transistor (TN13), an NMOS transistor (TN14) and a PMOS transistor (TP15) for driving said connection capacitor (Cext) which is connected at the output of the amplification means (AS), and a PMOS transistor (TP17) which contributes, when the shaping device is in standby mode, to the delivery of said zero-value rectangular output signal (NOUT).
